# EUROPÄISCHE PATENTANMELDUNG

(11) **EP 1 914 617 A2**
(43) Veröffentlichungstag der Anmeldung: **23.04.2008**
(21) Anmeldenummer: 07116350.5
(22) Anmeldetag: 13.09.2007
(51) Int. Cl.: G06F 1/18

(54) **Standfuß zur Aufnahme eines Computergehäuses**

(30) Priorität: 17.10.2006 DE 102006048968
(71) Anmelder: Fujitsu Siemens Computers GmbH, 80807 München (DE)
(72) Erfinder: Scherer, August, 86424 Dinkelscherben (DE); Kammerer, Corinna, 86399 Bobingen (DE)
(74) Vertreter: Epping - Hermann - Fischer

(57) **Zusammenfassung**

Die Erfindung betrifft einen Standfuß (2) zur Aufnahme eines Computergehäuses (1) zu dessen Kippsicherung auf einer Aufstellfläche. Der Standfuß (2) ist dadurch gekennzeichnet, dass er zwei Stellelemente (5) aufweist, die gegeneinander verschiebbar miteinander verbunden sind. Die zwei Stellelemente (5) weisen jeweils einen Basisschenkel (3) auf zur Auflage des Standfußes (2) auf der Aufstellfläche, und jeweils ein senkrecht zum Basisschenkel (3) verlaufendes Stützelement (4) zur seitlichen Stützung eines aufgenommenen Computergehäuses (1).

## Beschreibung

Die Erfindung betrifft einen Standfuß zur Aufnahme eines Computergehäuses zu dessen Kippsicherung auf einer Aufstellfläche.

Soll ein Computergehäuse auf einer Aufstellfläche aufgestellt werden, oder auf dieser gegen ein Verschieben gesichert werden, wird zur Kippsicherung oft ein Standfuß benötigt, der an das jeweilige Computergehäuse angepasst ist. Wichtig sind Standfüße insbesondere, wenn Desktop-Personal-Computer, die sich normalerweise flach auf einem Schreibtisch erstrecken, senkrecht gestellt werden sollen. Bei senkrechter Anordnung ist die Standfläche verhältnismäßig klein, so dass die Gefahr des Umfallens besteht. Ein solch speziell angefertigter Standfuß wird mit dem jeweiligen Computergehäuse verschraubt. Das Computergehäuse wird dafür mit entsprechenden Schraublöchern versehen.

Wird das Computergehäuse geöffnet, beispielsweise für Wartungsarbeiten oder für eine Montage oder Austausch von Computerkomponenten, wird der jeweilige spezielle Standfuß demontiert und das Computergehäuse ist frei zugänglich.

Der Erfindung liegt daher die Aufgabe zugrunde, einen Standfuß anzugeben, der eine einfache Kippsicherung des Computergehäuses auf einer Aufstellfläche ermöglicht.

Die Aufgabe wird durch einen Standfuß zur Aufnahme eines Computergehäuses zu dessen Kippsicherung auf einer Aufstellfläche gelöst, der dadurch gekennzeichnet ist, dass der Standfuß zwei Stellelemente aufweist, die gegeneinander verschiebbar miteinander verbunden sind. Die zwei Stellelemente weisen jeweils einen Basisschenkel auf zur Auflage des Standfußes auf der Aufstellfläche, und jeweils ein senkrecht zum Basisschenkel verlaufendes Stützelement zur seitlichen Stützung eines aufgenommenen Computergehäuses.

Der Vorteil der Erfindung ist, dass der Standfuß zwei Stellelemente aufweist, die gegeneinander verschiebbar miteinander verbunden sind. So kann ein universeller Standfuß bereitgestellt werden, der erst bei der Montage an die Größe des Computergehäuses angepasst werden muss. Die zwei Stellelemente weisen jeweils einen Basisschenkel auf, womit der Standfuß über die Auflageflächen der Basisschenkel auf der Aufstellfläche aufliegt. Ein in den Standfuß aufgenommenes Computergehäuse stützt dieses seitlich über senkrecht zum Basisschenkel verlaufende Stützelemente. Der Standfuß ist für Computergehäuse verschiedener Breite oder Tiefe geeignet und unabhängig von dem Computergehäuse selbst. Die seitlichen Stützelemente ermöglichen eine sehr gute Kippsicherung, insbesondere auch für Computergehäuse die auf einer Seite kleinster Grundfläche aufgestellt werden. Eine Verschraubung mit dem Computergehäuse ist durch die gute seitliche Stütze nicht erforderlich. Wenn das Computergehäuse geöffnet werden muss, so kann der Standfuß einfach abgezogen werden, ohne dass Werkzeug benutzt werden muss.

In einer vorteilhaften Ausgestaltung der Erfindung sind beide Stellelemente dazu eingerichtet, ineinander verschoben zu werden und dabei in einer Vielzahl von Positionen miteinander zu verrasten. Dadurch ist der Standfuß individuell an jedes Computergehäuse anpassbar und bleibt in der eingestellten Konfiguration.

In diesem Zusammenhang ist es vorteilhaft, dass eine Rastvorrichtung durch einen Schnapphaken des einen Stellelements und eine diesem gegenüber liegende Zahnreihe des anderen Stellenelements gebildet ist, wobei der Schnapphaken und die Zahnreihe zusammenwirken. Durch die Rastvorrichtung ist sichergestellt, dass der Standfuß seine Einstellung beibehält, wenn der Standfuß auf das Computergehäuse eingestellt worden ist. Durch den Schnapphaken und die Zahnreihe ist auf eine einfache Weise eine Vielzahl von Rastpositionen ermöglicht.

Besonders vorteilhaft ist eine Ausführung der Erfindung, bei der jedes der Stellelemente mindestens eine Zahnreihe und mindestens einen Schnapphaken aufweisen, wobei die Zahnreihen und Schnapphaken jeweils zum Zusammenwirken mit einem Schnapphaken bzw. einer Zahnreihe des anderen Stellelementes eingerichtet sind. Die Zahnreihen und Schnapphaken eines jeden Stellelements sind derart zueinander angeordnet, dass mindestens zwei Rastvorrichtungen gebildet sind, wobei durch eine versetzte Anordnung immer nur eine der Rastvorrichtungen einrastet. Dadurch ergibt sich eine feine Rastteilung und eine sehr genaue Anpassung des Standfußes an das Computergehäuse.

Ein weiterer Vorteil einer Weiterbildung der Erfindung ist, dass der jeweilige Basisschenkel der Stellelemente auf einer dem Computergehäuse zugewandten Seite jeweils eine erhobene Stellfläche aufweist, auf der ein aufgenommenes Gehäuse in dessen Randbereich aufliegt. Die Auflageflächen für das Computergehäuse sind dadurch auf eine minimale Fläche reduziert, nämlich den erhobenen Stellflächen. Das Computergehäuse ist ansonsten von den Basisschenkeln der Stellelemente beabstandet. Dadurch werden eventuell vorhandene Lüftungslöcher nicht abgedeckt und die Lüftung des Computergehäuses wird nicht behindert.

Ein weiterer Vorteil der Erfindung ist, dass der Standfuß dazu eingerichtet ist, das Computergehäuse schraubenlos aufzunehmen. Durch die beidseitigen Stützelemente der zwei Stellelemente des Standfußes erlaubt der Standfuß eine schraubenlose Aufnahme des Computergehäuses. Das Computergehäuse wird beispielsweise in zwei Standfüße gestellt. Zum Öffnen des Computergehäuses kann dieses einfach aus den Standfüßen herausgehoben werden. Am Computergehäuse selbst müssen keine weiteren Befestigungsmöglichkeiten vorgesehen werden. Ebenso könnte man einen besonders breiten Standfuß vorsehen, der alleine einen sicheren Stand des Computergehäuses ermöglicht.

Ein weiterer Vorteil einer Weiterbildung der Erfindung ist, dass das Computergehäuse ein Gehäuse eines Desktop-Personal-Computer ist. Insbesondere ein vertikal aufgestellter Desktop-Personal-Computer wird durch den Standfuß auf einer Aufstellfläche gegen ein Verschieben gesichert.

Ein weiterer Vorteil wird erreicht, wenn die Stellelemente identisch sind. Dadurch können die Fertigungskosten sowie auch die Lagerkosten deutlich verringert werden. Des Weiteren ist für einen Benutzer ein einfaches Handhaben des Standfußes gewährleistet.

Weitere Vorteile der Erfindung sind Gegenstand von Unteransprüchen.

Die Erfindung wird im Folgenden anhand von Ausführungsbeispielen in Verbindung mit schematischen Figuren näher erläutert. In den Figuren zeigen:
- Figur 1: einen Standfuß mit aufgenommenen Computergehäuse
- Figur 2: einen Standfuß,
- Figur 3A: eine Seitenansicht eines Stellelements,
- Figur 3B: eine Draufsicht des Stellelements,
- Figur 3C: eine weitere Seitenansicht des Stellelements,
- Figur 3D: eine Unteransicht des Stellelements,
- Figur 4: eine Unteransicht des Standfußes,
- Figur 5: eine Seitenansicht des Standfußes,
- Figur 6A: eine Brandschutzplatte,
- Figur 6B: eine Seitenansicht des Stellelements,
- Figur 6C: eine Seitenansicht des Standfußes mit Brandschutzplatte und
- Figur 6D: eine Vergrößerung eines Bereichs aus Figur 6C.

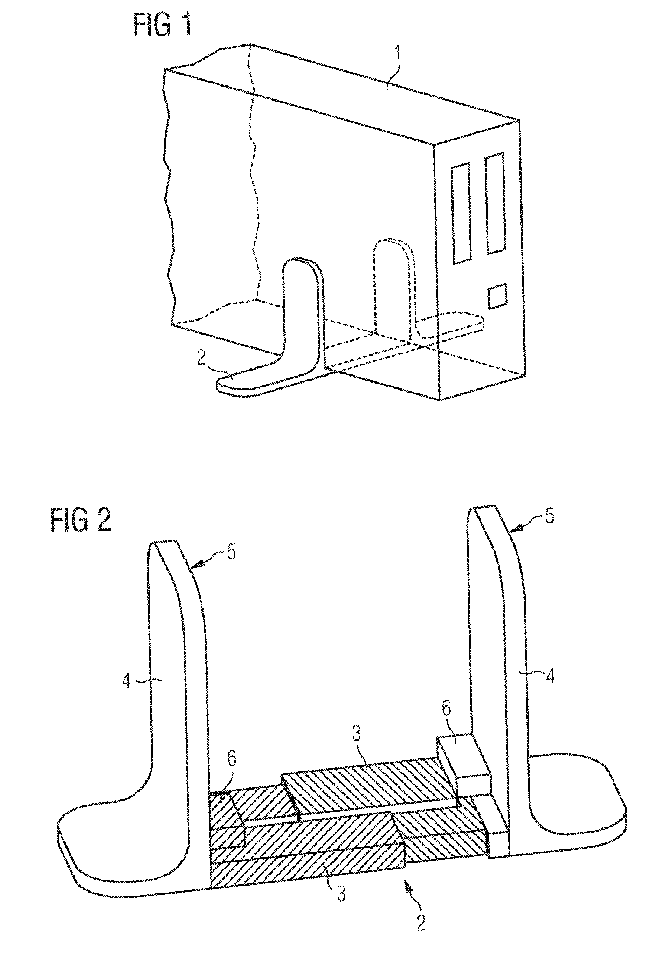

Figur 1 zeigt ein Computergehäuse 1, das in einem Standfuß 2 steht und von diesem auf der Aufstellfläche gehalten wird. In diesem Ausführungsbeispiel ist das Computergehäuse 1 ein Desktop-Personal-Computer. Es wird in der Figur 1 nur einer von vorzugsweise zwei Standfüßen 2 gezeigt, die eine Kippsicherung für das Computergehäuse 1 auf der Aufstellfläche sind. Es ist auch möglich, dass nur ein Standfuß 2 verwendet wird. Dann müsste er entweder so breit sein, dass er alleine das Computergehäuse 1 halten kann oder es könnte im zum Beispiel hinteren Bereich der Gehäuseunterseite ein Unterlegelement vorgesehen werden, so das dass Computergehäuse 1 gerade steht.

Figur 2 zeigt den Standfuß 2 ohne Computergehäuse 1 zur besseren Ansicht des Standfußes 2.

Der Standfuß 2 weist zwei Stellelemente 5 auf, die miteinander verrastet sind, wobei die Rastelemente in der Figur 2 nicht dargestellt sind. Jedes der zwei Stellelemente 5 weist jeweils einen Basisschenkel 3 und ein dazu senkrecht verlaufendes Stützelement 4 auf. Jeder der zwei Basisschenkel 3 weist auf einer dem Computergehäuse 1 zugewandten Seite jeweils eine Stellfläche 6 auf, auf der ein aufgenommenes Computergehäuse 1 aufsteht.

Die Basisschenkel 3 der zwei Stellelemente 5 sind in der Darstellung von Figur 2 in einem verrasteten Zustand. Die Entfernung zwischen den Stützelementen 4 entspricht bei richtiger Einstellung der Breite des Computergehäuses 1. Das Computergehäuse wird auf die jeweiligen Stellflächen 6 der zwei Stellelemente 5 aufgestellt. Die Stellflächen 6 sind im Ausführungsbeispiel der Figur 2 versetzt zueinander angeordnet. Die Stellflächen 6 weisen vorzugsweise ein Gummielement auf, dass beispielsweise auf die Stellfläche 6 zugeschnitten und auf die Stellfläche 6 aufgeklebt ist. Das Computergehäuse 1 wird seitlich mit den Stützelementen 4 gestützt. Dadurch wird ein Umfallen des Computergehäuses 1 oder ein seitliches Verschieben des Computergehäuses 1 auf dem Standfuß 2 verhindert. Es ist auch möglich Gummielemente an der Innenseite der Stützelemente 4 anzuordnen, so dass das Computergehäuse 1 zusätzlich gegen Verschieben/Verrutschen gesichert ist.

Die zwei Stellelemente 5 sind aus Kunststoff gefertigt und sind identisch. Die identische Ausgestaltung entspricht einem bevorzugten Ausführungsbeispiel der Erfindung, ist aber nicht zwingend erforderlich. Die Höhe der Stützelemente 4 ist dabei derart gewählt, dass eine ausreichende Sicherung gegen seitliches Kippen des Computergehäuses 1 gewährleistet ist. Die Höhe der Stützelemente 4 ergibt sich aus der Höhenlage des Schwerpunktes des Computergehäuses 1. Beispielsweise sind durch die Wahl der Höhe der Stützelemente 4 verschiedenartigen Computergehäuse 1 gegen seitliches Kippen ausreichend gesichert. Wird beispielsweise das Computergehäuse 1 um fünf Grad seitlich gekippt, entsprechend der Europäischen Norm für Sicherheitsanforderungen EN 60950, ist die Höhe der Stützelemente 4 so gewählt, dass das Computergehäuse 1 dabei nicht seitlich umkippt.

Das Computergehäuse 1 wird durch die Stützelemente 4 seitlich gestützt. Am Computergehäuse 1 selbst muss keine Befestigungsmöglichkeit vorhanden sein, beispielsweise Gewindelöcher. Das Computergehäuse 1 wird in dem Standfuß 2 schraubenlos gehalten.

Zum Öffnen des Computergehäuses 1, wird dieses aus dem Standfuß 2 herausgenommen, ohne dass eine weitere Montage beziehungsweise Demontage nötig ist.

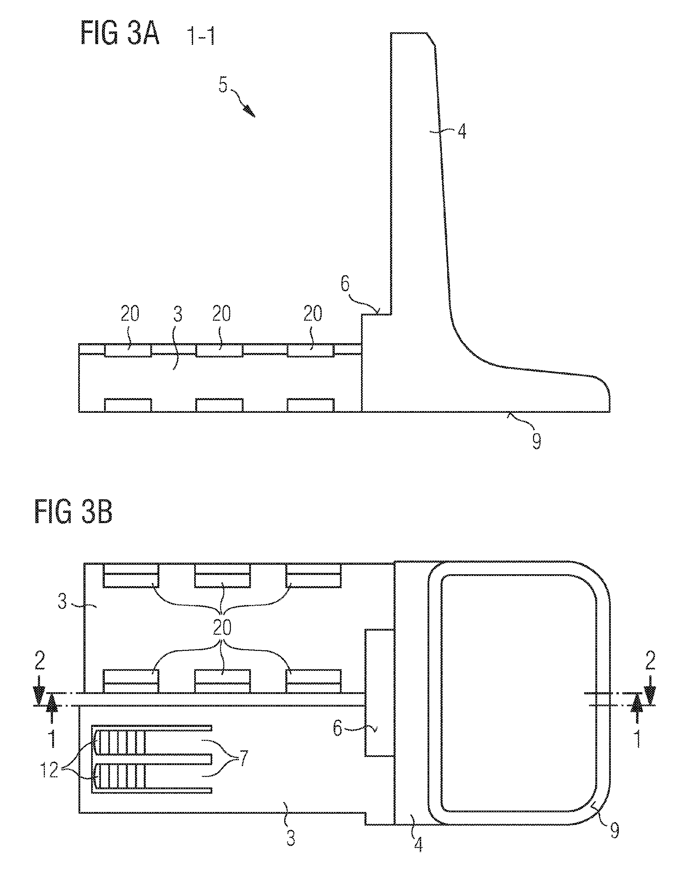

Ein einzelnes Stellelement 5 ist in den Figuren 3A bis 3D aus verschiedenen Perspektiven gezeigt.

Figur 3A zeigt eine Seitenansicht des Stellelements 5 im Schnitt 1-1 der Figur 3B. Das Stellelement 5 weist den Basisschenkel 3 und das dazu senkrecht stehende Stützelement 4 auf. In den Basisschenkel 3 sind in diesem Ausführungsbeispiel Öffnungen 20 eingebracht, die aus Gründen der Entformbarkeit vorhanden sind. Des Weiteren weist das Stellelement 5 eine Stützfläche 9 auf, die auf der Aufstellfläche aufliegt. Das Computergehäuse 1 selbst liegt auf der Stellfläche 6 auf und wird vom Stützelement 4 gestützt.

Figur 3B zeigt eine Draufsicht des Stellelements 5. Auf dem Basisschenkel 3 ist die Oberseite zweier Schnapphaken 7 zu sehen. Die Schnapphaken 7 sind in einer Ausnehmung im Basisschenkel 3 angeordnet. Die Schnapphaken 7 sind in diesem Ausführungsbeispiel jeweils als Zunge ausgebildet, die an einer Seite fest mit dem Basisschenkel 3 verbunden sind und ansonsten frei sind. Im vorderen freien Bereich der Schnapphaken 7 weisen diese jeweils Rastmittel 12 auf.

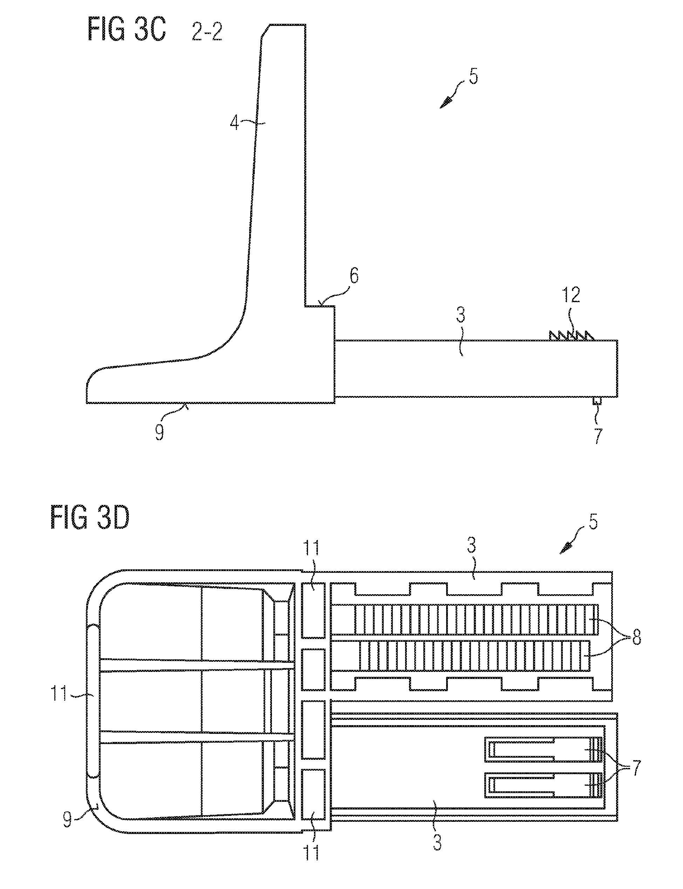

Figur 3C zeigt eine Seitenansicht des Stellelements 5 im Schnitt 2-2 aus Figur 3B. Die Rastmittel 12 der Schnapphaken 7 sind wie ein Sägezahn ausgebildet. Wird das Stellelement 5 in einer Richtung verschoben, rasten die Schnapphaken 7 über die Rastmittel 12 ein. In der entgegengesetzten Richtung sperren die Rastmittel 12 in gegenüberliegenden Gegenrastelementen des anderen Stellelements 5 ein und verhindern ein Lösen des Stellelements 5 aus seiner Verrastung.

Figur 3D zeigt eine Unteransicht des Stellelements 5. Der Basisschenkel 3 weist zwei nebeneinander liegende Zahnreihen 8 auf, die in diesem Ausführungsbeispiel gegeneinander versetzt sind. Die Versetzung beträgt beispielsweise 1 Millimeter.

Der Basisschenkel 3 weist die zwei Schnapphaken auf. Die Schnapphaken 7 sind als Zunge ausgebildet mit einer senkrecht zur Zunge ausgebildeten, sich auf der Unterseite des Stellelements 5 befindlichen Lasche.

Die Stützfläche 9 des Stellelements 5 weist Gummielemente 11 auf, die ein Verrutschen des Stellelements 5 auf der Aufstellfläche verhindern. In diesem Ausführungsbeispiel sind drei Gummielemente 11 rechteckig geformt und im äußeren und inneren Bereich der Stützfläche 9 angeordnet. Verschiedene weitere Formen der Gummielemente 11 für verschiedene weitere Formen der Stützfläche 9 oder des Stellelements 5 sind auch möglich.

In einer vorteilhaften Weiterbildung ist es möglich, die zwei Zahnreihen 8 des Stellelements 5 gegeneinander nicht zu versetzen und die Schnapphaken 7 mit unterschiedlich langen Zungen auszubilden, so dass eine feine Rastteilung erreicht werden kann. Beispielsweise sind die Zungen der Schnapphaken 7 um einen Millimeter unterschiedlich lang und rasten beispielsweise alle zwei Millimeter in einer der Zahnreihen 8 ein.

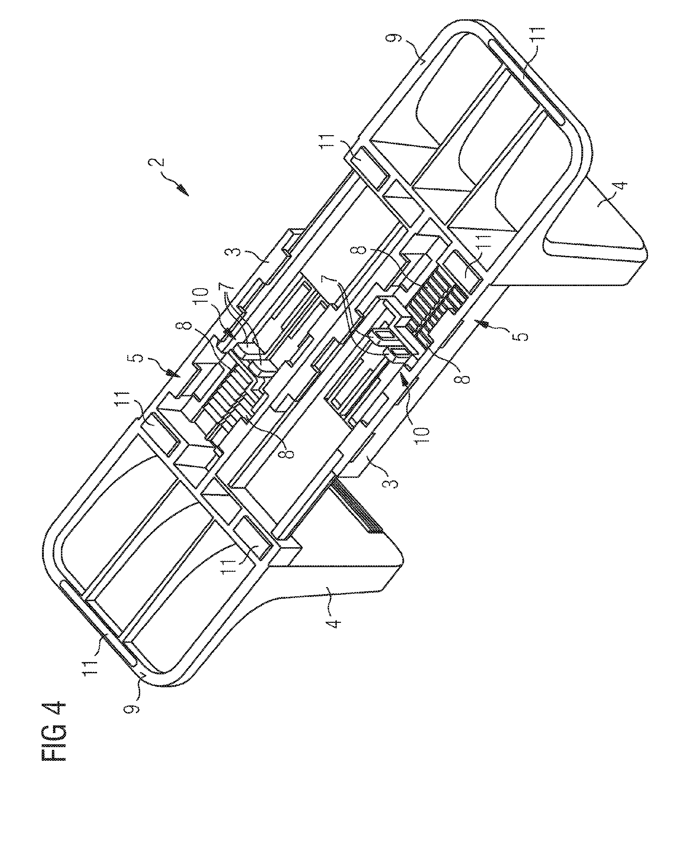

Figur 4 zeigt eine Unteransicht des Standfußes 2. Die zwei Stellelemente 5 sind ineinander verrastet.

Der jeweilige Basisschenkel 3 des einen Stellelements 5 wird in den Basisschenkel 3 des anderen Stellelements 5 hineingeschoben. Die zwei Stellelemente 5 sind identisch geformt.

Der Standfuß 2 weist zwei Rastvorrichtungen auf, die jeweils aus den Schnapphaken 7 des einen Stellelements 5 und den Zahnreihen 8 des anderen Stellelements 5 gebildet sind. Dabei verrasten die Rastmittel 12 der Schnapphaken 7 des einen Stellelements 5 federnd mit den Zahnreihen 8 des anderen Stellelements 5, wenn die zwei Stellelemente 5 gegeneinander verschoben werden, das heißt aufeinander zu geschoben werden. In der entgegengesetzten Richtung, nämlich voneinander weg, lassen sich die Stellelemente 5 nicht mehr bewegen. Dazu muss die Verrastung erst gelöst werden. Dies kann beispielsweise durch ein Ziehen an den Schnapphaken 7 von der Unterseite des Standfußes 2 aus erfolgen.

In diesem Ausführungsbeispiel liegen die Zahnreihen 8 eines Stellelements 5 nebeneinander und sind gegeneinander versetzt. Jeweils einer der Schnapphaken 7 rastet federnd beispielsweise alle zwei Millimeter in einer der Zahnreihen 8 ein. Die beiden Zahnreihen 8 eines Stellelements 5 sind in einer vorteilhaften Ausgestaltung um einen Millimeter zueinander versetzt. Dadurch ergibt sich für den Standfuß 2 eine Rastteilung von einem Millimeter, also eine feine Rastteilung, womit der Standfuß 2 sehr genau auf die Breite des Computergehäuses 1 eingestellt werden kann.

Die Länge der Schnapphaken 7, genauer gesagt die Länge der Zunge der Schnapphaken 7 ist vorteilhafterweise dermaßen gestaltet, dass die Zunge nicht zu kurz ist, weil es dann in Folge einer Überdehnung zu einem Weissbruch kommen kann. Ist die Zunge des Schnapphakens 7 hingegen zu lang, ist sie zu weich und eine Verrastung ist nicht mehr möglich.

Jedes der zwei Stützelemente 4 weist auf der Unterseite eine Stützfläche 9 auf. Auf der jeweiligen Stützfläche 9 sind vorzugsweise Gummielemente 11 befestigt, um dem Standfuß 2 eine bessere Haftung auf einer Stellfläche, wie zum Beispiel einem Tisch zu ermöglichen.

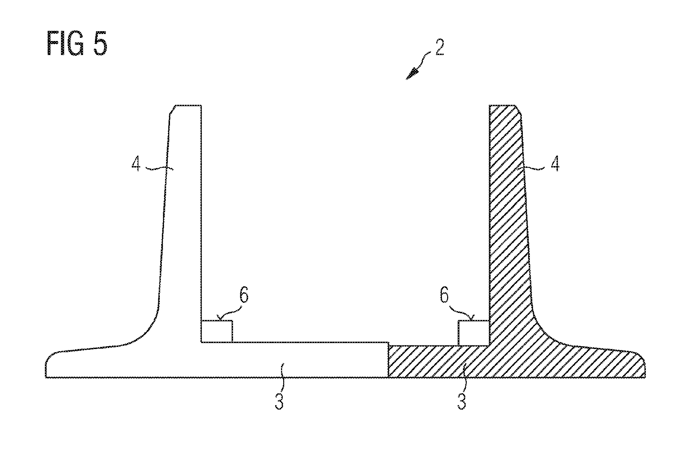

Figur 5 zeigt eine Seitenansicht des Standfußes 2. Die zwei Stellelemente 5 sind ineinander verrastet. Der Standfuß 2 nimmt das Computergehäuse 1 auf. Das Computergehäuse 1 wird in seinem Randbereich auf die Stellflächen 6 des Standfußes 2 gestellt.

Es ist möglich das Computergehäuse 1 in zwei Standfüße 2 zu stellen oder in einen einzelnen breiten Standfuß 2. In allen Fällen ist das Computergehäuse vorzugsweise beabstandet von dem Basisschenkel 3 der zwei Stellelemente 5 angeordnet. Die Auflagefläche des Computergehäuses 1 ist auf eine minimale Fläche, nämlich die Stellfläche 6 reduziert. Dadurch sind eventuell vorhandene Lüftungslöcher nicht verdeckt. Eine optimale Belüftung des Computers wird nicht behindert.

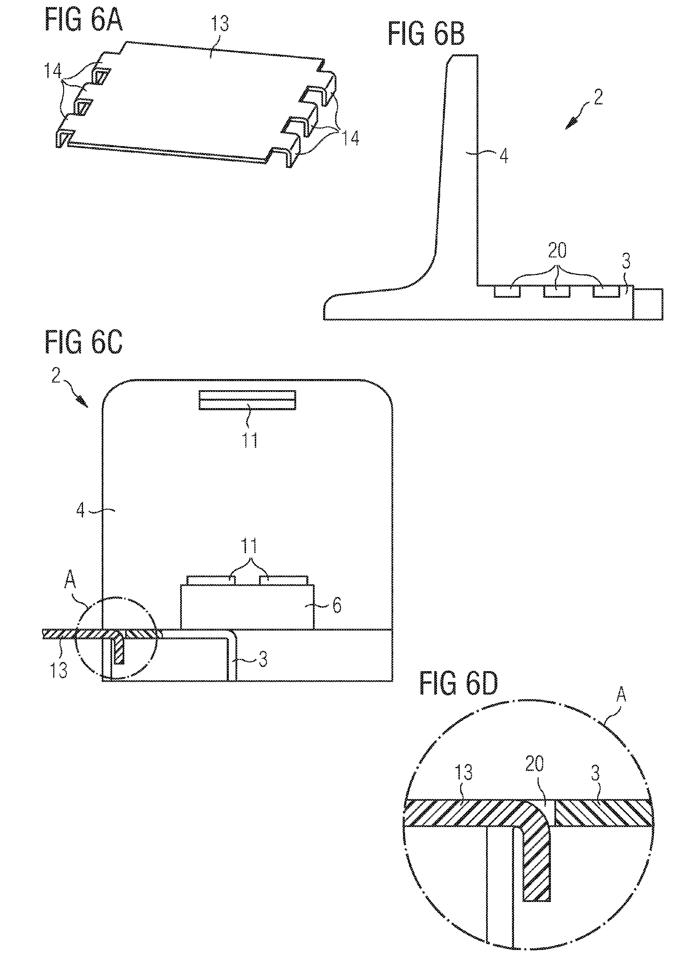

Der Standfuß 2 bietet die Möglichkeit, eine Brandschutzplatte 13 zu montieren. In den Figuren 6A bis 6D wird eine Brandschutzplatte 13, ein Stellelement 5 und die im Standfuß 2 eingehackte Brandschutzplatte 13 gezeigt.

Die Brandschutzplatte 13 in Figur 6A ist beispielsweise aus Blech oder aus Kunststoff gefertigt und entspricht den Sicherheitsanforderungen aus der Europäischen Norm EN 60950. Diese Sicherheitsanforderungen schreiben beispielsweise vor, dass im Boden eines Computergehäuses 1 Löcher mit einem maximalen Durchmesser von 2,0 Millimeter, bei einer Mindestblechstärke von 1,0 Millimeter sein dürfen. Daraus ergibt sich ein Mindestlochabstand von 3,0 Millimeter (Tabelle 15 "Größe und Abstand der Löcher in Metallböden von Brandschutzumhüllungen", EN 60950).

Weisen die Be- und Entlüftungslöcher einen Durchmesser von 4,0 Millimeter oder größer auf, kann es vorkommen, dass beispielsweise heißer Kunststoff oder glühende Partikel aus dem Computergehäuse 1 durch die Be- und Entlüftungslöcher fallen. Um den Sicherheitsanforderungen der EN 60950 zu genügen, ist es möglich eine Brandschutzplatte 13 an den Standfuß 2 zu montieren. Die Brandschutzplatte 13 weist dazu Haken 14 auf.

In die Öffnungen 20 auf dem Basisschenkel 3 des Stellelements 5, wie in Figur 6B gezeigt, werden die Haken 14 der Brandschutzplatte 13 eingehängt. Die Öffnungen 20 befinden sich in diesem Ausführungsbeispiel in jedem Basiselement 3 der beiden Standfüße 2 in die das Computergehäuse 2 aufgenommen ist. Die Öffnungen 20 werden meist aus Gründen der Entformbarkeit schon bei der Herstellung in die Basiselemente 3 eingebracht.

Figur 6C zeigt einen Schnitt durch einen Standfuß 2 mit eingehängter Brandschutzplatte 13. Das Computergehäuse 1 wird im Standfuß 2 auf die Aufstellflächen 6 aufgestellt. Gegen Verrutschen sind auf den Aufstellflächen 6 und am Stützelement 4 Gummielemente 11 angebracht.

Der Bereich des Standußes 2 in dem die Brandschutzplatte 13 eingehängt wird, ist in Figur 6D in der Vergrößerung gezeigt. Die Haken 14 der Brandschutzplatte 13 sind in die Öffnungen 20 der Basisschenkel 3 eingehängt.

Weitere Ausführungsbeispiele und vorteilhafte Weiterbildungen der Erfindung sind hier nicht weiter angegeben, werden aber von der Erfindung umfasst.

### Bezugszeichenliste

- 1: Computergehäuse
- 2: Standfuß
- 3: Basisschenkel
- 4: Stützelement
- 5: Stellelement
- 6: Stellfläche
- 7: Schnapphaken
- 8: Zahnreihe
- 9: Stützfläche
- 10: Rastvorrichtung
- 11: Gummielement
- 12: Rastmittel
- 13: Brandschutzplatte
- 14: Haken
- 20: Öffnung

## Patentansprüche

1. Standfuß (2) zur Aufnahme eines Computergehäuses (1) zu dessen Kippsicherung auf einer Aufstellfläche,
**dadurch gekennzeichnet, dass**
der Standfuß (2) zwei Stellelemente (5) aufweist,
die gegeneinander verschiebbar miteinander verbunden sind und
die jeweils einen Basisschenkel (3) aufweisen zur Auflage des Standfußes (2) auf der Aufstellfläche, und
die jeweils ein sich senkrecht zum Basisschenkel (3) verlaufendes Stützelement (4) aufweisen zur seitlichen Stützung eines aufgenommenen Computergehäuses (1).

2. Standfuß (2) nach Anspruch 1,
**dadurch gekennzeichnet, dass**
die beiden Stellelemente (5) dazu eingerichtet sind, ineinander verschoben zu werden, und in einer Vielzahl von Positionen miteinander zu verrasten.

3. Standfuß (2) nach Anspruch 1,
**dadurch gekennzeichnet, dass**
eine Rastvorrichtung (10) durch einen Schnapphaken (7) des einen Stellelements (5) und eine diesem gegenüberliegende Zahnreihe (8) des anderen Stellelements (5) gebildet ist, wobei der Schnapphaken (7) und die Zahnreihe (8) zusammenwirken.

4. Standfuß (2) nach Anspruch 3,
**dadurch gekennzeichnet, dass**
jedes der Stellelemente (5) mindestens eine Zahnreihe (8) und mindestens einen Schnapphaken (7) aufweist,
wobei die Zahnreihen (8) und Schnapphaken (7) jeweils zum Zusammenwirken mit einem Schnapphaken (7) bzw. einer Zahnreihe (8) des anderen Stellelementes (5) eingerichtet sind und
wobei die Zahnreihe (8) und der Schnapphaken (7) eines jeden Stellelements (5) derart zueinander angeordnet sind, dass mindestens zwei Rastvorrichtungen (10) gebildet sind, wobei durch eine versetzte Anordnung immer nur eine der Rastvorrichtungen (10) einrastet.

5. Standfuß (2) nach Anspruch 1,
**dadurch gekennzeichnet, dass**
der jeweilige Basisschenkel (3) der Stellelemente (5) auf einer dem Computergehäuse (1) zugewandten Seite jeweils eine erhobene Stellfläche (6) aufweist, auf der ein aufgenommenes Computergehäuse (1) in dessen Randbereich aufliegt.

6. Standfuß (2) nach Anspruch 1 und 2,
**dadurch gekennzeichnet, dass**
der Standfuß (2) dazu eingerichtet ist, das Computergehäuse (1) schraubenlos aufzunehmen.

7. Standfuß (2) nach einem der Ansprüche 1 bis 6,
**dadurch gekennzeichnet, dass**
das Computergehäuse (1) ein Gehäuse eines Desktop-Personal-Computer umfasst.

8. Standfuß (2) nach einem der Ansprüche 1 bis 7,
**dadurch gekennzeichnet, dass**
die Stellelemente (5) identisch sind.
